Europäisches Patentamt

European Patent Office

Office européen des brevets

(11) Publication number: **0 365 031**
**A2**

# EUROPEAN PATENT APPLICATION

(21) Application number: **89119525.7**

(22) Date of filing: **20.10.89**

(51) Int. Cl.5: **G03F 7/027 , G03H 1/20 , G03F 7/00**

(30) Priority: **21.10.88 JP 266586/88**
**21.10.88 JP 266587/88**
**21.10.88 JP 266588/88**
**21.10.88 JP 266589/88**
**22.04.89 JP 103160/89**

(43) Date of publication of application:
**25.04.90 Bulletin 90/17**

(84) Designated Contracting States:
**CH DE FR GB LI**

(71) Applicant: **Toppan Printing Co., Ltd.**
**5-1, 1-chome, Taito**
**Taito-ku Tokyo(JP)**

(72) Inventor: **Inaba, Yoshimi**
**308 Sunny-Heights 1-21-10, Sengendainishi**
**Koshigaya-shi Saitama-ken(JP)**
Inventor: **Okano, Shigeru**
**2208 Shinmachi-Heights 575-2, Ooeda**
**Kasukabe-shi Saitama-ken(JP)**
Inventor: **Nishijima, Katsunori**
**3051 Ooazakurihashi Kurihashi-machi**
**Kitakatsushika-gun Saitama-ken(JP)**

(74) Representative: **Bühling, Gerhard, Dipl.-Chem.**
**et al**
**Patentanwaltsbüro Tiedtke-Bühling-Kinne**
**Grupe-Pellmann-Grams-Struif-Roth**
**Bavariaring 4**
**D-8000 München 2(DE)**

(54) **Hologram stamper, method of manufacturing the same, and method of manufacturing hologram.**

(57) A relief type hologram stamper (B) which comprises as a hologram relief pattern formation layer a resin layer (2) comprising an electron beam- or ultraviolet rays-curable acrylate resin having a surface tension of not less than 35 dyn/cm, and formed on an electron beam-or ultraviolet rays-transmitting film or sheet support (1). A fine relief pattern can be formed on the surface of the resin layer (2) by pressing a hologram mother (A) plate having a fine relief pattern (3) onto the surface of the resin layer (2) and subsequently irradiating an electron beam or ultraviolet rays to cure the resin layer (2). This stamper (B) is used to form a hologram on a substrate having a thermoplastic resin surface layer by means of a hot-pressing method.

FIG. 1A

FIG. 1C

## Hologram stamper, method of manufacturing the same, and method of manufacturing hologram

The present invention relates to the manufacture of a hologram and, more particularly, to a relief type hologram stamper and a method of manufacturing the same and a method of efficiently manufacturing a hologram.

A hologram for reproducing a three-dimensional image has a good artistic design and is therefore used as cover pages of, e.g., books and magazines, POP displays, gifts, and the like. In addition, since a hologram is equivalent to recording information of the order of submicrons, it is used to prevent forgery of securities, credit cards, and the like.

In order to mass-produce a relief type hologram, a die manufactured by metal plating or the like from a photoresist on which an embossed relief pattern is formed is generally used as a mother plate to hot-press mold a thermoplastic resin coated on a substrate, thereby manufacturing a large number of holograms. In this method, however, since the die requires a large number of manufacturing steps, it is difficult to control quality, and much time and many labors are necessary, resulting in an expensive product.

In order to solve the above problem, therefore, Published Unexamined Japanese Patent Application No. 58-184986 discloses a method in which an electron beam- or ultraviolet rays-curable resin, a thermoplastic resin, or a thermosetting resin is used as a stamper instead of a die. In this method, upon manufacture of a resin plate, an electron beam- or ultraviolet rays-curable resin is directly brought into contact with the surface of a photopolymer as a mother plate to form a relief pattern. In this case, in order to precisely reproduce a relief pattern of a hologram mother plate, a wetting property between the photopolymer and the curable resin must be excellent. Since, however, an adhesion strength between the photopolymer and the curable resin is increased as the wetting property is improved, it is practically very difficult to peel an initial relief pattern while keeping it in good conditions. Even if the relief pattern is peeled, the relief pattern cannot be prevented from being damaged by a cohesive failure or the like in the photopolymer or curable resin. In addition, the type of curable resin useful therefor is very strictly limited.

In the invention disclosed in Published Unexamined Japanese Patent Application No. 58-184986 described above, upon manufacture of a stamper hologram using a resin plate, an electron beam- or ultraviolet rays-curable resin is brought into contact with the resin plate, and is cured and shaped by electron beam or ultraviolet rays radiation. Therefore, since the resin plate itself may be degraded upon repetitive radiation of high-energy rays, it is difficult to maintain stable quality.

It is an object of the present invention to use an electron beam- or ultraviolet rays-curable resin as a hologram relief pattern formation layer, thereby reducing the number of hologram stamper manufacturing steps and saving a time required for the manufacturing steps.

It is another object of the present invention to provide a method, based on hot-press embossing which is simple in principle, for manufacturing a large number of holograms having a clear image and stable quality on a thermoplastic resin within a short time period.

In order to achieve the above objects, the present inventors have made extensive studies and attained the present invention in which a resin layer containing an electron beam- or ultraviolet rays-curable acrylate resin having a surface tension of 35 dyn/cm or more is used as a relief pattern formation layer so that the relief pattern formation layer can be easily peeled from a mother plate, and this relief pattern formation layer is used as a stamper to reduce the number of stamper manufacturing steps and stabilize product quality.

That is, according to the present invention, there is provided a hologram stamper comprising: a resin layer comprising an electron beam- or ultraviolet rays-curable acrylate resin having a surface tension of 35 dyn/cm or more, and preferably, 35 to 55 dyn/cm, and formed on an electron beam- or ultraviolet rays-transmitting film or sheet support; and a fine relief pattern formed on the surface of the resin layer, wherein the relief pattern is cured by an electron beam or ultraviolet rays.

In addition, according to the present invention, there is provided a method of manufacturing a hologram stamper, comprising the steps of: forming a resin layer comprising a resin containing at least an electron beam- or ultraviolet rays-curable resin or a monomer, and having a surface tension of 35 dyn/cm or more, on an electron beam- or ultraviolet rays-transmitting film or sheet support; bringing a hologram mother plate having a fine relief pattern into contact with the resin layer; irradiating an electron beam or ultraviolet rays to cure the resin layer; and peeling the resin layer from the hologram mother plate.

Note that the above relief pattern formation resin layer may further contain, in addition to the acrylate resin, a polymerizable monomer containing fluorine atoms in molecules or a thermosetting resin.

The above acrylate resin is preferably, e.g., an ester acrylate, epoxy acrylate, or urethane acrylate containing at least two acryloyl group in one molecule.

2

Although the electron beam- or ultraviolet rays-transmitting support is not particularly limited, an aromatic polyester film or sheet is preferably used in view of its excellent adhesion property with respect to the resin layer.

When a thermosetting resin is contained as the resin layer, a two-step curing method is preferably adopted. That is, in the two-step curing method, a resin layer is brought into contact with a hologram mother plate, irradiated and precured by an electron beam or ultraviolet rays, peeled from the hologram mother plate, and then heated and completely cured.

Note that the above resin layer may further contain a thermoplastic resin.

The hologram mother plate may be manufactured by coating a thin metal film on a hologram relief pattern. Alternatively, the hologram mother plate may be manufactured by forming a peelable photoresist layer on a substrate, curing a resin layer by an electron beam or the like, peeling the resin layer from the substrate together with the photoresist layer, and then dissolving and removing only the photoresist layer by a solvent.

This invention can be more fully understood from the following detailed description when taken in conjunction with the accompanying drawings, in which:

Figs. 1A to 1C are sectional views showing a method of manufacturing a hologram stamper according to an embodiment of the present invention in an order of steps;

Figs. 2A to 2C and 3A to 3C are sectional views showing methods of manufacturing a hologram stamper according to other embodiments of the present invention in orders of steps, respectively; and

Figs. 4A and 4B are sectional views showing a method of manufacturing a hologram by using the hologram stamper according to the present invention.

Embodiments of the present invention will be described in detail below with reference to the accompanying drawings.

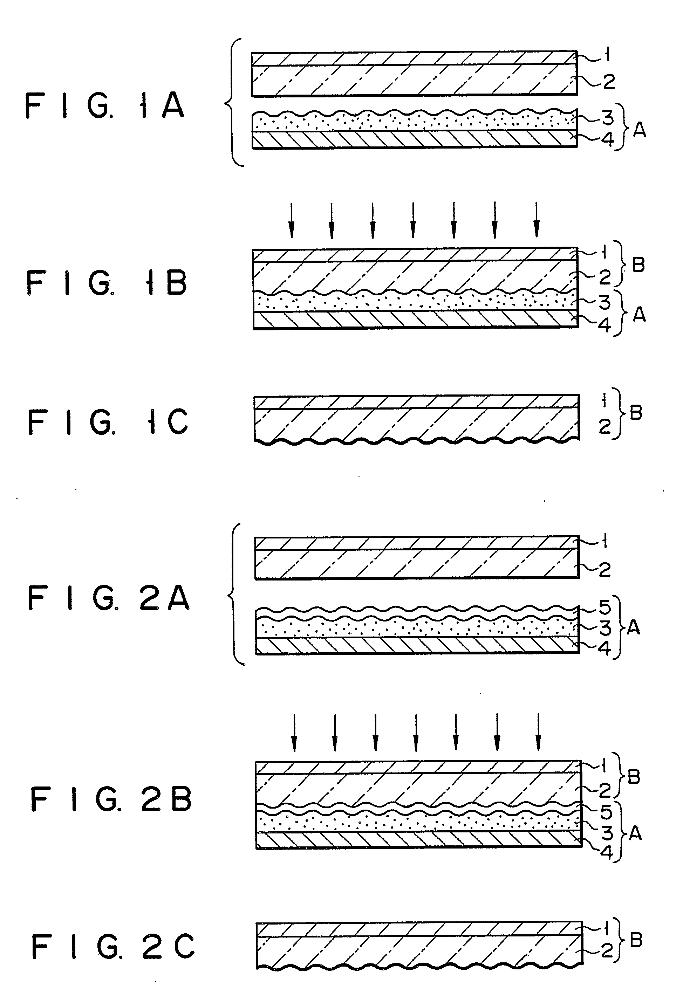

Referring to Fig. 1, reference numeral 1 denotes a film or sheet support; 2, a resin layer consisting of an electron beam-curable acrylate resin having a surface tension of 35 dyn/cm or more; 3, a photoresist layer on which a relief pattern as a hologram mother plate A is formed; and 4, a photoresist substrate. The substrate 4 is generally a glass plate.

In the present invention, the film or sheet support 1 having an electron beam transparency must have, e.g., proper heat resistance, mechanical strength, and surface smoothness so that the support 1 can withstand heat applied on a thermoplastic resin of a hologram stamping resin plate in a post step and heat applied upon heat-press embossing. More specifically, examples of the material usable for the support 1 are polyester, polycarbonate, polyetherimide, polyphenylenesulfide, polyimide, polyetherketone, and glass. An aromatic polyester prepared by condensation of an aromatic dicarboxylic acid and bisphenol is most preferable in terms of an adhesion property with respect to the resin layer 3. Normally, the thickness of the support 1 is preferably 20 to 200 $\mu$m.

As the electron beam-curable acrylate having a surface tension of 35 dyn/cm or more for use in the resin layer 2, an ester acrylate, epoxy acrylate, and urethane acrylate can be used. In this case, an acrylate capable of forming a curable film which is of at least bifunctional and has a high crosslinking density is preferable. Examples of the acrylate are trimethylolpropanetriacrylate, ECH-modified ethyleneglycoldimethacrylate, PO,EO-modified bisphenol-A-diacrylate, EO-modified bisphenol-A-dimethacrylate, pentaerythritoltriacrylate, EO-modified phosphate diacrylate, ECH-modified glyceroltriacrylate, ECH-modified glyceroltriacrylate, ECH-modified phthalic diacrylate, and triallylisocyanurate, trimethylolpropane diacrylate, modified neopentylglycol. These compounds can be used in a combination of two or more thereof.

The resin layer 2 can contain a polymerizable monomer having fluorine atoms in molecules in addition to the above acrylate resin. In this case, an acrylate resin having a low acidic value has a high miscibility. More specifically, the acid value is preferably 2.0 or less.

The polymerizable monomer containing fluorine atoms in molecules preferably contains an acryloyl group as a radical polymerizable group. Examples are 2,2,2-trifluoroethylacrylate,
2,2,2-trifluoroethylmethacrylate,
undecafluorocyclohexylacrylate,
nonafluorocyclopentylacrylate,
pentadecafluorooctylmethacrylate,
2,3- bis(difluoroamino)propylacrylate,
2,2,2-trifluoro-1-(trifluoromethyl)ethylacrylate,
2,2-difluoro-2-nitroethylacrylate,
1,2,2,2-tetrafluoro-1-(trifluoromethyl)ethylacrylate,
2,2,3,3-tetrafluoro-3-(trifluoromethoxy)propylacrylate, 2,2,3,3,4,4,4-heptafluorobutylacrylate,
2,2,3,3,4,4-hexafluoro-1,5-pentadiilacrylate.

3

A mixing ratio between the electron beam- or ultraviolet rays-curable acrylate and the polymerizable monomer containing fluorine atoms in molecules in the resin layer 2 preferably falls within the range of 3 : 1 to 2 : 1 (weight ratio). The mixing ratio, however, is not limited to this range since an optimal mixing ratio changes as, e.g., the type of material or a film or sheet substrate to be used is changed.

The resin layer 2 may contain a thermosetting high-temperature resin in addition to the above acrylate resin. In this case, examples of a thermosetting resin having good high-temperature properties to be used as the thermosetting high-temperature resin are a high-temperature epoxy resin, a high-temperature phenol resin, a melamine resin, a silicone resin, and a polyimide resin.

A mixing ratio between the electron beam- or ultraviolet rays-curable acrylate and the thermosetting high-temperature resin preferably falls within the range of 1 : 10 to 1 : 4 (weight ratio). The mixing ratio, however, is not limited to this range since an optimal mixing ratio changes as, e.g., the type of material, electron beam- or ultraviolet rays-curing conditions, or heat-curing conditions are changed.

Although a generally, widely used semiconductor resist can be used as the photoresist layer 3 on which a relief pattern of the hologram mother plate A is formed, a positive resist having a high resolution is most preferable. Such a positive resist is commercially available as AZ-1350 or AZ-2400 (tradename: available from Cypray Co., Ltd.) or Way Coat HPR (tradename: Hunt Co., Ltd.) A glass plate is normally used as the photoresist substrate 4 because the substrate 4 requires a smoothness.

Steps of manufacturing a hologram stamper will be described below.

First, in Fig. 1A, an electron beam-curable acrylate resin having a surface tension of 35 dyn/cm or more is coated on the film or sheet support 1 by a known method such as knife coating, spin coating, bar coating or roll coating, thereby forming the resin layer 2. The resultant structure is then brought into contact with the surface of the photoresist 3 having a three-dimensional pattern of the hologram mother plate A.

The photoresist 3 is coated on a 2- to 3-mm thick glass plate to have a film thickness of about 1 to 3 $\mu$m, exposed by an argon laser, and developed by a predetermined developing agent, thereby manufacturing a relief image.

As shown in Fig. 1B, the resin layer is cured by radiating an electron beam or ultraviolet rays from the support 1 side and peeled from the surface of the hologram mother plate A, thereby obtaining a hologram stamper B constituted by the support and the cured resin layer as shown in Fig. 1C. In this case, an electron beam radiation amount is preferably 1.0 Mrad or more in order to sufficiently perform a curing reaction. In the case of ultraviolet rays, a radiation amount is preferably 100 mJ/cm$^2$ or more.

Figs. 2A to 2C show another embodiment in which a structure obtained by forming a thin metal film 5 on the upper surface of a relief pattern 3 of a hologram mother plate is used as a hologram mother plate. In this case, examples of a material of the film 5 are aluminum, gold, silver, copper, tin, and alloys containing these metals. The conventional vacuum deposition method, sputtering method, ion plating method, or the like can be utilized as a film formation method. The film thickness preferably falls within the range of 100 to 10,000 Å.

In this embodiment, a hologram stamper can be manufactured by the same method as shown in Figs. 1A to 1C.

That is, as shown in Fig. 2A, a resin solution containing an electron beam- or ultraviolet rays-curable resin or a monomer is coated on a support 1 by a known method such as knife coating, thereby forming a resin layer 2. The resultant structure is brought into contact with a thin metal film 5 of a hologram mother plate.

As shown in Fig. 2B, the resin layer 2 is cured by radiating an electron beam or ultraviolet rays from the support 1 side and peeled from the surface of the thin metal film 5 of the hologram mother plate A. When the resin layer is a mixture with a thermosetting resin, the resin layer is further heated and completely cured after it is peeled. As a result, as shown in Fig. 2C, a hologram stamper B constituted by the support and the resin layer is obtained.

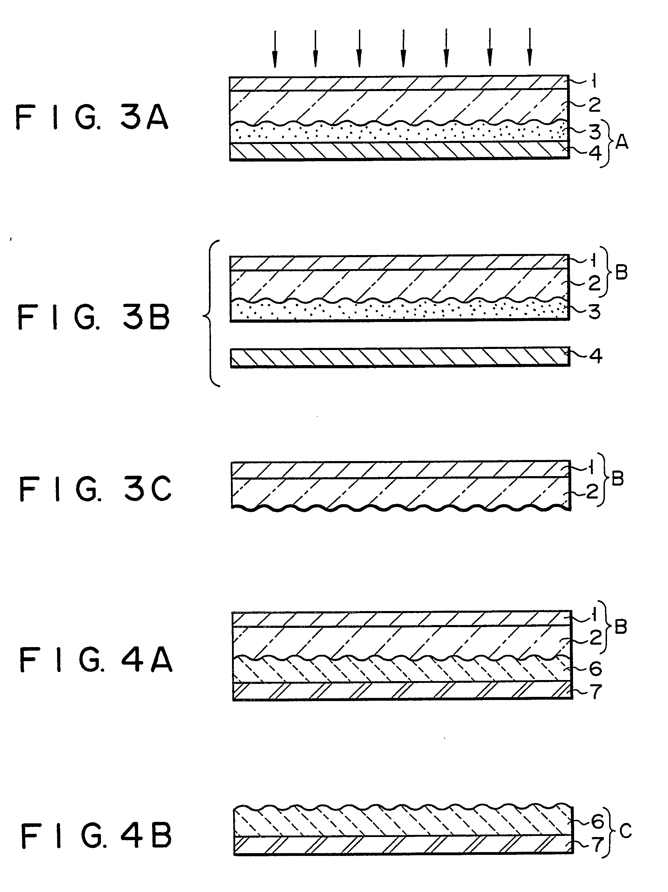

Figs. 3A to 3C show still another embodiment of a method of manufacturing a hologram stamper. First, a resin layer 2 consisting of a resin solution containing an electron beam- or ultraviolet rays-curable resin or a monomer is coated on a support by a known method such as spin coating, bar coating, roll coating or knife coating. The resultant structure is brought into contact with the surface of a photoresist layer 3 of a hologram mother plate A, as shown in Fig. 1A (Fig. 3A). An electron beam or ultraviolet rays are radiated from the support 1 side to cure the resin layer 2.

As shown in Fig. 3B, the resultant structure is subjected to peeling at the interface between the photoresist layer 3 and the substrate 4. In order to improve a peeling property, a primer is preferably not used in the photoresist coating step. The photoresist layer 3 is then removed. In this case, a solvent which dissolves not the cured resin layer but only the photoresist layer 3 is selected, or the photoresist layer is exposed again and removed by a predetermined developing agent. As a result, a hologram stamper B consisting of the support and the resin layer is obtained as shown in Fig. 3C.

The hologram stamper B obtained in any of the above embodiments is used in the manufacture of a hologram stamped product according to a method shown in Figs. 4A and 4B.

That is, as shown in Fig. 4A, the hologram stamped product B obtained in the above method is brought into contact with a thermoplastic resin layer 6, subjected to hot-press embossing, and then peeled from the layer 6, thereby manufacturing a hologram stamped product C as shown in Fig. 4B.

Note that in Figs. 4A and 4B, reference numeral 6 denotes a thermoplastic resin layer; and 7, a substrate for the thermoplastic resin.

The thermoplastic resin layer 6 may consist of, e.g., a polyester resin, polystyrene, a styrene-acryl copolymer, polyvinyl chloride, a polyvinyl acetate, a polyvinyl chloride-vinyl acetate copolymer, polyvinyl acetal, an alkyd resin resin, an acrylic resin, polyacrylonitrile, and polycarbonatepolyketone.

Examples of the substrate 7 of the thermoplastic resin are polyester, polypropylene, polycarbonate, and cellophane. The electron beam- or ultraviolet rays-transmitting film can also be used. In this case, the film or sheet preferably has a thickness of about 10 to 100 $\mu$m.

The present invention will be described in more detail below by way of its examples.

(Example-1)

A MICROPOSIT 1350 (available from Cypray Co.) was used as a photoresist to form a photoresist layer having a film thickness of about 1.5 $\mu$m on a substrate consisting of a 3-mm thick glass plate. An interference fringe of a three-dimensional object was exposed by an argon laser (wavelength = 457.9 nmqand intensity = 50 mJ/cm2) for about 10 minutes, and a relief hologram was manufactured by alkali development, thereby obtaining a hologram mother plate.

An electron beam-curable ECH-modified ethyleneglycoldimethacrylate (DENACOL DM-811 available from NAGASE & CO., LTD.) having a surface tension of 41.4 dyn/cm was coated on a support consisting of a 70-$\mu$m thick polyester film to have a film thickness of about 5 $\mu$m by wire bar coating, thereby forming a resin solution layer. The surface tension was measured by an automatic surface tension meter (CBVP-A3 available from Kyowa Kaimen Kagaku K.K.) The resin solution layer was brought into contact with a relief surface of the hologram mother plate, and an electron beam of 200 keV was radqated at an absorbed dose of 5 Mrad from the support side. Thereafter, the resultant structure was peeled from the hologram mother plate to obtain a hologram stamper consisting of the support and the cured resin layer. Peeling between the cured resin layer and the photoresist as a hologram mother plate was good, i.e., a 90° peel strength was 5.2 g/cm.

A thermoplastic resin layer having the following composition was coated on a substrate consisting of a 50-$\mu$m thick polyester film to have a thickness of about 15 $\mu$m by using a wire bar, thereby manufacturing a hologram-reproducing film.

| DIANAL BR-101 (acrylic resin, available from Mitsubishi Rayon Co., Ltd.) | 30 parts by weight |
| Isopropanol | 70 parts by weight |

The relief surface of the hologram stamper was brought into contact with the thermoplastic resin layer surface of the hologram-reproducing film at a pressure of about 25 kg/cm² and heated at a temperature of 130°C for five seconds from the support surface of the hologram stamper. Thereafter, the thermoplastic resin layer surface was peeled from the hologram stamper to obtain a stamped hologram product. No blocking occurred upon peeling, and a hologram giving a good, sharp, and clear image was obtained.

(Example-2)

An electron beam-curable trimethylolpropanetriacrylate (KAYARAD TMPTA available from NIPPON KAYAKU CO., LTD.) having a surface tension of 37.0 dyn/cm was coated on a support consisting of a 75-$\mu$m thick polyimide film (UPILEX 75S, corona treatment grade, available from Ube Industries, Ltd.) to have a thickness of about 5 $\mu$m by using a wire bar, thereby forming a resin layer. Thereafter, a hologram stamper was manufactured following the same procedures as in Example-1. Peeling between the cured resin layer and the photoresist was good, i.e., a 90° peel strength was 3.5 g/cm.

Following the same procedures as in Example-1, a relief pattern was manufactured on a thermoplastic resin layer similar to that used in Example-1, thereby manufacturing a stamped hologram product. As a result, a clear hologram similar to that obtained in Example-1 was obtained.

(Example-3)

A hologram stamper was manufactured following the same procedures as in Example-1 except that a PO,EO-modified bisphenol-A-diacrylate (NK ester A-BPE-4, available from Shin Nakamura Kagaku K.K.) having a surface tension of 45.6 dyn/cm was used as an electron beam-curable resin. Peeling with respect to a photoresist mother plate was good, i.e., a 90° peel strength was 10.8 g/cm. In addition, a hot-press embossing suitability for a thermoplastic resin was excellent, and a good stamped hologram product as in Example-1 was obtained.

(Comparative Example-1)

An electron beam was radiated to perform peeling following the same procedures as in Example-1 except that a neopentylglycoldiacrylate (KAYARAD NPGDA, available from NIPPON KAYAKU CO., LTD.) having a surface tension of 32.8 dyn/cm was used as an electron beam-curable resin. Since, however, an adhesion strength between the cured resin and a photoresist as a hologram mother plate was high, only a polyester film as a support was peeled.

(Comparative Example-2)

An electron beam-curable hydroxy pivalic acid ester neopentylglycoldiacrylate (KAYARAD MANDA, available from NIPPON KAYAKU K.K.) having a surface tension of 34.2 dyn/cm was coated on a 75-$\mu$m thick polyimide film (UPILEX 75R, available from Ube Industries, Ltd.) to have a film thickness of about 5 $\mu$m by using a wire bar.

An electron beam was radiated following the same procedures as in Example-1, and then peeling was performed.

As in Comparative Example-1, however, since an adhesion strength between a cured resin and a photoresist was high, the resultant structure was peeled from the surface of glass as a photoresist substrate. The above results are summarized in Table 1 below.

Table 1

|  | Surface Tension (dyn/cm) | Peel Strength (g/cm) | Peeling State |
|---|---|---|---|
| Example-1 | 41.4 | 5.2 | good |
| Example-2 | 37.0 | 3.5 | good |
| Example-3 | 45.6 | 10.8 | good |
| Comparative Example-1 | 32.8 | Unmeasurable | Only Support Was Peeled |
| Comparative Example-2 | 34.2 | Unmeasurable | Peeled From Substrate Surface |

(Example-4)

AZ-1350 (Cypray Co.) was used as a photoresist to form a 1.5-$\mu$m thick photoresist layer on a substrate consisting of a 3-mm thick glass plate, and an interference fringe of a three-dimensional object was exposed by an argon laser (wavelength = 457.9 nm and intensity = 50 mJ/cm$^2$) for about 10 minutes.

EP 0 365 031 A2

Thereafter, a relief hologram was manufactured by alkali development to be used as a hologram mother plate.

An electron beam- or ultraviolet rays-curable solution mixture having the following composition was coated on a support consisting of a 70-μm thick polyester film by wire bar coating to have a film thickness of about 10 μm, thereby forming a resin layer. The resin layer was brought into contact with the relief surface of the hologram mother plate, and an electron beam of 200 keV was radiated at an absorbed dose of 4 Mrad from the support side. Thereafter, the resultant structure was peeled from the hologram mother plate to obtain a hologram stamper consisting of the support and the cured resin layer.

| | |
|---|---|
| Electron beam-curable trifunctional acrylate (KAYARAD TMPTA: available from NIPPON KAYAKU CO., LTD.) | 70 parts by weight |
| 2,2,2-trifluoroethylmethacrylate | 30 parts by weight |

A thermoplastic resin layer having the following composition was coated on a substrate consisting of a 50-μm thick polyester film by using a wire bar to have a thickness of about 15 μm, thereby manufacturing a hologram-reproducing film.

| | |
|---|---|
| DIANAL BR-101 (available from Mitsubishi Rayon Co., Ltd.) | 40 parts by weight |
| Isopropanol | 60 parts by weight |

The relief surface of the hologram stamper was brought into contact with the thermoplastic resin layer surface of the hologram-reproducing film at a pressure of about 25 kg/cm² and heated at a temperature of 130°C for five seconds from the support surface of the hologram stamper. Thereafter, the thermoplastic resin layer surface was peeled from the hologram stamper to obtain a stamped hologram product. No blocking or adhesion was found upon peeling, and a hologram giving a good, sharp, and clear image was obtained.

(Example-5)

A resin solution having the following composition was coated on a support consisting of a 100-μm thick polyester film by using a wire bar to have a thickness of about 10 μm, thereby forming a resin layer. After the resin layer was brought into contact with the relief surface of a hologram mother plate following the same procedures as in Example-4, ultraviolet rays having an intensity of 400 mJ/cm² were radiated from the support side to cure the resin layer. Thereafter, the cured resin layer was peeled to manufacture a hologram stamper.

| | |
|---|---|
| Ultraviolet rays-curable bifunctional acrylate (KAYARAD R-604: available from NIPPON KAYAKU CO., LTD.) | 40 parts by weight |
| Ultraviolet rays-curable oligomer (Trimethylolpropane diacrylate, modified neopentylglycol) (KAYARAD HX-220: available from NIPPON KAYAKU CO., LTD.) | 25 parts by weight |
| Pentadecafluorooctyl methacrylate | 35 parts by weight |
| Benzoinisobutylether | 0.4 parts by weight |

Following the same procedures as in Example-4, a relief pattern was formed on a thermoplastic resin layer similar to that used in Example-4, thereby manufacturing a stamped hologram product. As a result, a clear hologram as in Example-4 was obtained.

7

(Example-6)

A relief hologram was manufactured following the same procedures as in Example-4 to be used as a hologram mother plate.

A solution mixture of an electron beam-curable acrylate resin and a thermosetting high-temperature resin having the following compositions was coated on a support consisting of a 75-$\mu$m thick polyimide film (UPILEX 75S, available from Ube Industries, Ltd.) by wire bar coating to have a thickness of about 10 $\mu$m, and soft baking for removing a solvent was performed at 80°C for one minute and at 100°C for five minutes, thereby forming a resin layer. The resin layer was brought into contact with the relief surface of the hologram mother plate and irradiated with an electron beam of 200 keV at an absorbed dose of 5 Mrad from the support side. Thereafter, the resultant resin layer was peeled from the relief surface of the hologram mother plate to form a hologram prestamper consisting of the support and the precured resin. This prestamper was heated and completely cured at 300°C for 90 minutes, thereby manufacturing a hologram stamper.

| | |
|---|---|
| Electron beam-curable bifunctional acrylate (KAYARAD R-604: available from NIPPON KAYAKU CO., LTD.) | 15 parts by weight |
| Thermosetting resin (Trimethylolpropane diacrylate, modified neopentylglycol) (BILALIN PI-2555: available from Du Pont de Nemours, E.I., Co.) | 90 parts by weight |

A thermoplastic resin having the following composi tion was coated on a substrate consisting of a 50-$\mu$m thick polyester film by using a wire bar to have a thickness of about 15 $\mu$m, thereby manufacturing a stamped hologram film.

| | |
|---|---|
| DIANAL BR-101 (available from Mitsubishi Rayon Co., Ltd.) | 40 parts by weight |
| Isopropanol | 60 parts by weight |

The relief surface of the hologram stamper was brought into contact with the thermoplastic resin layer surface of the stamped hologram film at a pressure of about 25 kg/cm$^2$ and heated at 130°C for five seconds from the support surface of the hologram stamper. Thereafter, the thermoplastic layer surface was peeled from the hologram stamper to obtain a hologram stamped product. As a result, a hologram giving a good, sharp, and clear image was obtained.

(Example-7)

A solution mixture of ultraviolet rays-curable acrylate and a thermosetting high-temperature resin having the following compositions was coated on a support consisting of a 100-$\mu$m thick polyester film by using a wire bar to have a thickness of about 10 $\mu$m, and soft baking for removing a solvent was performed at 80°C for five minutes, thereby forming a resin layer. Following the same procedures as in Example-6, the resin layer was brought into contact with the relief surface of a hologram mother plate, and irradiated and precured by ultraviolet rays having an intensity of 500 mJ/cm$^2$ from the support side. Thereafter, the precured resin layer was peeled from the hologram stamper, and heated and completely cured at 180°C for one hour, thereby manufacturing a hologram stamping resin plate.

8

| Ultraviolet rays-curable trifunctional acrylate (KAYARAD TMPTA: available from NIPPON KAYAKU CO., LTD.) | 10 parts by weight |
|---|---|
| Thermosetting resin (polyimide) (CHEMITITE CT410: available from TOSHIBA CHEMICAL CORP.) | 90 parts by weight |
| Benzoinisobutylether | 0.4 parts by weight |

Following the same procedures as in Example-6, a relief pattern was formed on a thermoplastic resin layer to obtain a hologram stamped product. As a result, a clear hologram similar to that in Example-6 was obtained.

(Example-8)

MICROPOSIT 1350 (available from Cypray Co.) was used as a photoresist to form a photoresist layer having a film thickness of about 1.5 $\mu$m on a 3-mm thick glass plate. Thereafter, instead of an interference fringe of a three-dimensional object, an interference fringe of 1,300 line/min was exposed by a two-beam interfering method using an argon laser (wavelength = 457.9 nm and intensity = 50 mJ/cm$^2$) to form a grating by alkali development. This grating was used in place of a hologram mother plate.

Neopentylglycol-modified trimethylolprapanediacrylate as an electron beam-curable acrylate was coated on a support consisting of a 70-$\mu$m thick aromatic polyester film by wire bar coating to have a film thickness of about 5 $\mu$m, thereby forming a resin solution layer. The resin solution layer was brought into contact with the relief surface of the grating used instead of a hologram mother plate and irradiated with an electron beam of 200 keV at an absorbed dose of seven Hrad from the support side. Thereafter, the resin layer was peeled from the hologram mother plate to obtain a hologram stamper constituted by the support and the cured resin layer. A peeling properly between the cured resin layer and the photoresist was good.

A thermoplastic resin layer having the following composition was coated on a substrate consisting of a 50-$\mu$m thick polyester film by using a wire bar to have a thickness of about 15 $\mu$m, thereby manufacturing a stamped hologram film.

| DIANAL BR-101 (available from Mitsubishi Rayon Co., Ltd.) | 40 parts by weight |
|---|---|
| Isopropanol | 60 parts by weight |

The relief surface of the hologram stamper was brought into contact with the thermoplastic layer surface of the stamped hologram film at a pressure of about 40 kg/cm$^2$ and heated at 160$^\circ$C for three seconds from the support surface of the hologram stamper. Thereafter, the thermoplastic resin layer surface was peeled from the hologram stamper to obtain a stamped hologram product. After a similar hot-press emboss-stamping step was repeated 100 times, the stamper remained unchanged, and a stamped product giving clear and sharp diffracted light was obtained.

(Example-9)

An electron beam-curable acrylate having the following composition was coated on a support consisting of a 100-$\mu$m thick aromatic polyester film by using a wire bar to have a film thickness of about 5 $\mu$m, thereby forming a resin layer. Thereafter, a hologram stamper was manufactured following the same procedures as in

Example-8.

| Trimethylolpropanetriacrylate | 70 parts by weight |
| ECH-modified ethyleneglycoldimethacrylate | 30 parts by weight |

A relief pattern was formed on a thermoplastic resin layer similar to that used in Example-8 following the same procedures as in Example-8, thereby manufacturing a stamped product. As in Example-8, after stamping was performed 100 times, a stamped product giving clear diffracted light was obtained.

(Example-10)

AZ-1350 (available from Cypray Co.) was used as a photoresist to form a photoresist layer having a film thickness of about 1.5 μm on a substrate consisting of a 3-mm thick glass plate. An interference fringe of a three-dimensional object was exposed by an argon laser (wavelength = 457.9 nm and intensity = 50 mJ/cm$^2$) for about 10 minutes, and alkali development was performed. The resultant structure was dried, and a thin Al film having a film thickness of about 1,000 Å was formed on the relief surface by a vacuum deposition method to be used as a hologram mother plate.

An electron beam- or ultraviolet rays-curable resin having the following composition was coated on a support consisting of a 70-μm thick polyester film by wire bar coating to have a film thickness of about 10 μm, thereby forming a resin layer. The resin layer was brought into contact with the Al-deposited surface of the hologram mother plate and irradiated with an electron beam of 200 keV at an absorbed dose of 5 Mrad from the support side, thereby manufacturing a hologram stamper consisting of the hologram film and the cured resin. A peeling property between the hologram mother plate and the resin layer was good.

| Electron beam-curable bifunctional acrylate monomer (KAYARAD MANDA: available from NIPPON KAYAKU CO., LTD.) | 60 parts by weight |
| Electron beam-curable bifunctional urethaneacrylate oligomer (NK ester u-108-A: available from Shin Nakamura Kagaku K.K.) | 40 parts by weight |

A thermoplastic resin having the following composition was coated on a support consisting of a 50-μm thick polyester film by using a wire bar to have a thickness of about 15 μm, thereby manufacturing a stamped hologram film.

| DIANAL BR-101 (available from Mitsubishi Rayon Co., Ltd.) | 40 parts by weight |
| Isopropanol | 60 parts by weight |

The relief surface of a hologram stamping resin plate was brought into contact with the thermoplastic layer surface at a pressure of about 25 kg/cm$^2$ and heated at 130°C for five seconds from the support surface of the hologram stamper. Thereafter, the thermoplastic resin layer surface was peeled from the hologram stamper to obtain a stamped hologram. As a result, a hologram giving a good, sharp, and clear image was obtained.

(Comparative Example-3)

A hologram stamper was manufactured following the same procedures as in Example-10 except that an electron beam- or ultraviolet rays-curable resin solution was directly brought into contact with the relief surface of a photoresist layer without forming an Al-deposited film on the relief surface of a hologram mother plate.

The resin layer was cured by electron beam radiation and peeled from the surface of the photopolymer as a hologram mother plate. Since, however, a cohesive failure occurred from inside the photopolymer layer

10

or peeling was produced from the photopolymer substrate surface, no practical hologram stamper could be obtained.

(Example-11)

AZ-1350 (available from Cypray Co.) was used as a photoresist to form a photoresist layer having a film thickness of about 1.5 μm on a substrate consisting of a 3-mm thick glass plate without using a primer. An interference fringe of a three-dimensional object was exposed by an argon laser (wavelength = 457.9 nm and intensity = 50 mJ/cm²), and a relief hologram was manufactured by alkali development to be used as a hologram mother plate.

An electron beam-curable resin having the following composition was coated on a support consisting of a 70-μm thick polyester film by wire bar coating to have a film thickness of about 10 μm, thereby forming a resin layer. The resin layer was brought into contact with the relief surface of the hologram mother plate and irradiated with an electron beam of 200 keV at an absorbed dose of 5 Mrad from the support side. The resultant structure was peeled at the interface between the photoresist layer and the glass plate as a substrate of the hologram mother plate. The photoresist layer was exposed by ultraviolet rays and removed in an alkali developing agent by an ultrasolic wave, thereby manufacturing a hologram stamper consisting of the polyester film and the cured resin. Since the relief pattern was not damaged, a good resin plate precisely reproducing the pattern of the hologram mother plate was obtained.

| | |
|---|---|
| Electron beam-curable difunctional acrylate (NK ester A-BPE-4, PO,EO-modified bisphenol-A-diacrylate, available from Shin Nakamura Kagaku K.K.) | 70 parts by weight |
| Electron beam-curable urethaneacrylate (NK ester u-108-A: available from Shin Nakamura Kagaku K.K.) | 30 parts by weight |

A thermoplastic resin having the following composition was coated on a support consisting of a 50-μm thick polyester film by using a wire bar to have a thickness of about 15 μm, thereby manufacturing a stamped hologram film.

| | |
|---|---|
| DIANAL BR-101 (available from Mitsubishi Rayon Co., Ltd.) | 40 parts by weight |
| Isopropanol | 60 parts by weight |

The relief surface of the hologram stamper was brought into contact with the thermoplastic resin layer surface of the stamped hologram film at a pressure of about 25 kg/cm² and heated at 120°C for five seconds from the support side of the hologram stamper. Thereafter, the thermoplastic resin layer surface was peeled from the hologram stamper to obtain a hologram stamped product. As a result, a hologram giving a good, sharp, and clear image was obtained.

(Example-12)

A resin solution having the following composition was coated on a support consisting of a 100-μm thick polyester film by using a wire bar to have a film thickness of about 10 μm and brought into contact with the relief surface of a hologram mother plate. Following the same procedures as in Example-11, the resin layer was cured by radiating ultraviolet rays having an intensity of 400 mJ/cm² from the polyester film side, and the photoresist layer was removed, thereby manufacturing a hologram stamper. The obtained stamper was good as that obtained in Example-11.

| Ultraviolet rays-curable bifunctional acrylate (KAYARAD MANDA: available from NIPPON KAYAKU CO., LTD.) | 70 parts by weight |
|---|---|
| Ultraviolet rays-curable oligomer (KAYARAD HX-220: available from NIPPON KAYAKU CO., LTD.) | 30 parts by weight |
| Benzoinisobutylether | 0.4 parts by weight |

A relief pattern was formed on the thermoplastic resin layer following the same procedures as in Example-11, thereby manufacturing a hologram stamped product. As a result, a clear hologram as in Example-11 was obtained.

A relief type hologram stamper (B) which comprises as a hologram relief pattern formation layer a resin layer (2) comprising an electron beam- or ultraviolet rays-curable acrylate resin having a surface tension of not less than 35 dyn/cm, and formed on an electron beam-or ultraviolet rays-transmitting film or sheet support (1). A fine relief pattern can be formed on the surface of the resin layer (2) by pressing a hologram mother (A) plate having a fine relief pattern (3) onto the surface of the resin layer (2) and subsequently irradiating an electron beam or ultraviolet rays to cure the resin layer (2). This stamper (B) is used to form a hologram on a substrate having a thermoplastic resin surface layer by means of a hot pressing method.

## Claims

1. A hologram stamper comprising: an electron beam- or ultraviolet rays-transmitting film or sheet support (1);
a resin layer (2) formed on said support; and
a fine relief pattern formed on the surface of said resin layer (2),
characterized in that said resin layer (2) comprises an electron beam- or ultraviolet rays-curable acrylate resin having a surface tension of not less than 35 dyn/cm.

2. A stamper according to claim 1, characterized in that said resin layer (2) further contains a polymerizable monomer containing fluorine atoms in molecules.

3. A stamper according to claim 1, characterized in that said resin layer (2) further contains a thermosetting resin.

4. A stamper according to claim 1, characterized in that said acrylate resin is selected from the group consisting of an ester acrylate, an epoxy acrylate, and an urethane acrylate containing at least two acryloyl groups in one molecule.

5. A stamper according to claim 1, characterized in that said support (1) comprises an aromatic polyester film or sheet.

6. A stamper according to claim 1, characterized in that a surface tension of said acrylate resin is 35 to 55 dyn/cm.

7. A method of manufacturing a hologram stamper, comprising the steps of:
forming a resin layer (2) comprising a resin containing at least an electron beam- or ultraviolet rays-curable resin or a monomer, and having a surface tension of not less than 35 dyn/cm, on an electron beam- or ultraviolet rays-transmitting film or sheet support (1);
bringing a hologram mother plate (A) having a fine relief pattern into contact with said resin layer (2);
irradiating an electron beam or ultraviolet rays to cure said resin layer (2); and
peeling said resin layer (2) from said hologram mother plate (A).

8. A method according to claim 7, characterized in that said resin layer (2) comprising a mixture of an electron beam- or ultraviolet rays-curable acrylate resin having a surface tension of not less than 35 dyn/cm and a thermosetting resin, said resin layer (2) being brought into contact with said hologram mother plate (A), irradiated and precured by an electron beam or ultraviolet rays, peeled from said hologram mother plate (A), and heated to be completely cured.

9. A method according to claim 8, characterized in that said resin layer further contains a thermoplastic resin.

10. A method according to claim 7, characterized in that said hologram mother plate is obtained by coating a thin metal film (5) on a relief pattern (3).

11. A method according to claim 7, characterized in that said hologram mother plate (A) comprises a photoresist layer (3) and a substrate (4) which can be peeled from said photoresist layer (3), and, after said resin layer (2) is brought into contact with said hologram mother plate (A), said resin layer (2) is irradiated and cured by an electron beam or ultraviolet rays, said substrate (4) of said hologram mother plate (A) is peeled and removed from said photoresist layer (3), and said photoresist layer (3) is dissolved and removed.

12. A method according to claim 7, characterized in that an electron beam or ultraviolet rays are radiated from the support side.

13. A method of manufacturing a hologram, characterized by comprising the steps of:

hot-pressing a stamper (B) according to claim 1 onto a thermoplastic resin layer of a substrate having said thermoplastic resin layer; and

removing said stamper (B).

F I G. 1A

F I G. 1B

F I G. 1C

F I G. 2A

F I G. 2B

F I G. 2C

F I G. 3A

F I G. 3B

F I G. 3C

F I G. 4A

F I G. 4B